# EUROPÄISCHE PATENTANMELDUNG

(11) **EP 4 807 383 A1**
(43) Veröffentlichungstag der Anmeldung: **16.09.2026**
(21) Anmeldenummer: 26161508.2
(22) Anmeldetag: 01.03.2026
(51) Int. Cl.: G01R 33/26, G01R 33/32, G01N 24/00

(54) **MAGNETOMETER UND VERFAHREN ZUR ERFASSUNG EINES MAGNETFELDES**

(30) Priorität: 13.03.2025 DE 102025109708
(71) Anmelder: Fraunhofer-Gesellschaft zur Förderung der angewandten Forschung e.V., 80686 München (DE)
(72) Erfinder: JESKE, Jan, 79108 Freiburg (DE); SCHALL, Florian Phillip, 79108 Freiburg (DE); LINDNER, Lukas, 79108 Freiburg (DE)
(74) Vertreter: Friese Goeden Patentanwälte PartGmbB

(57) **Zusammenfassung**

Die Erfindung betrifft ein Magnetometer (1) mit zumindest einem optischen Resonator (2), welcher einen ersten Spiegel (21) und einen gegenüberliegenden zweiten Spiegel (22) enthält, wobei im optischen Resonator und zumindest ein Diamant (3) angeordnet ist, welcher zumindest ein NV-Zentrum enthält und zumindest der erste Spiegel (21) strukturiert ist, so dass dieser eine Mehrzahl von räumlich separierten optischen Resonatoren (2a, 2b, ..., 2n) definiert. Weiterhin betrifft die Erfindung ein Verfahren zum Betrieb eines solchen Magnetometers (1).

## Beschreibung

Die Erfindung betrifft ein Magnetometer mit zumindest einem optischen Resonator, welcher einen ersten Spiegel und zumindest einen zweiten Spiegel enthält, wobei im optischen Resonator zumindest ein Diamant angeordnet ist, welcher zumindest ein NV-Zentrum enthält. Weiterhin betrifft die Erfindung ein Verfahren zum Betrieb eines solchen Magnetometers.

Aus Nathan S. Gottesman, Michael A. Slocum, Gary A. Sevison, Michael Wolf, Michal L. Lukowski, Chris Hessenius, Mahmoud Fallahi, Robert G. Bedford: "Infrared vertical external cavity surface emitting laser threshold Magnetometer." Appl. Phys. Lett. 26. Februar 2024, 124 (9) 091110 ist ein solches Magnetometer bekannt. Dieses bekannte Magnetometer umfasst zumindest einen Diamant, welcher zumindest ein NV-Zentrum enthält. Das NV-Zentrum weist zwei Spin-Triplett Zustände ³A₂ und ³E auf, welche durch grünes Pumplicht aus einer ersten Pumplichtquelle angeregt werden können. Der angeregte ³E-Zustand zerfällt entweder direkt durch einen strahlenden Übergang in den Grundzustand ³A₂ oder über zwei Singulett-Zustände ¹A, und ¹E, welche durch eine Energie (*h·c*)/(1042 nm) voneinander getrennt sind (mit der Planck-Konstante *h* und der Vakuumlichtgeschwindigkeit *c*). Das Spin-Triplett ³A₂ enthält drei Spinzustände mₛ = 0, -1 und +1. Durch HF- bzw. Mikrowellenstrahlung mit einer Frequenz von etwa 2,88 GHz kann ein Übergang zwischen den Spinzuständen mₛ = 0 und mₛ = ±1 angeregt werden. Die Anwesenheit eines Magnetfeldes ändert dabei die Resonanzfrequenz des Übergangs. Die Spinzustände mit mₛ = ±1 haben eine stärkere Kopplung an den absorbierenden Singulettzustand ¹E, sodass es zu einer magnetfeldabhängigen Absorption elektromagnetischer Strahlung bei 1042 nm kommt.

Dieser bekannte Magnetfeldsensor weist jedoch den Nachteil auf, dass die räumliche Auflösung gering ist, da das Messsignal über das gesamte Volumen des Diamant gemittelt wird.

Ausgehend vom Stand der Technik kann der Erfindung somit die Aufgabe zugrundeliegen, einen Magnetfeldsensor mit erhöhter Ortsauflösung bereitzustellen.

Nachfolgend wird ein Magnetometer gemäß Anspruch 1 und ein Verfahren nach Anspruch 10 beschrieben. Vorteilhafte Weiterbildungen finden sich in den Unteransprüchen.

Gemäß einem Aspekt wird ein Magnetometer vorgeschlagen. Das Magnetometer kann in einigen Ausführungsformen der Erfindung einen Resonator aufweisen. Der Resonator kann einen ersten Spiegel aufweisen, welcher an einem ersten Ende des Resonators angeordnet ist. Darüber hinaus kann der Resonator einen zweiten Spiegel aufweisen, welcher an einem zweiten Ende des Resonators angeordnet ist. In einigen Ausführungsformen der Erfindung kann das zweite Ende dem ersten Ende gegenüberliegen. Der erste und der zweite Spiegel sind zumindest in einem Teilspektrum des elektromagnetischen Spektrums reflektierend. Hierzu können die Spiegel eine oder mehrere Dünnschichten aufweisen. In einigen Ausführungsformen der Erfindung können mehrere Dünnschichten übereinander abgeschieden sein und auf diese Weise ein Schichtsystem bilden, welches durch Interferenz hohe Reflektivität in einem vorgebbaren Wellenlängenbereich ermöglicht. Der Resonator kann dazu eingerichtet und bestimmt sein, Licht mit zumindest einer vorgebbaren Wellenlänge durch mehrfache Reflexion zwischen dem ersten Spiegel und dem zweiten Spiegel im Resonator einzuschließen, wobei das Licht den Resonator mehrfach durchläuft. Der erste Spiegel und der zweite Spiegel können hierzu gegenüberliegend angeordnet sein. In einigen Ausführungsformen der Erfindung kann die Kavität auch mehr als zwei Spiegel aufweisen und beispielsweise einen polygonalen Strahlengang oder einen Z-förmigen Strahlengang aufweisen.

In einigen Ausführungsformen der Erfindung kann im Resonator, d.h. zwischen den beiden Spiegeln, zumindest ein Diamant angeordnet sein. Der Diamant kann einkristallin oder polykristallin sein. Der Diamant kann natürlicher Diamant sein. In anderen Ausführungsformen kann der Diamant künstlich hergestellt sein, beispielsweise mittels homoepitaktischer oder heteroepitaktischer Abscheidung aus einer Gasphase in einer Niederdrucksynthese. Eine solche Niederdrucksynthese kann eine Chemical Vapour Deposition beinhalten. In anderen Ausführungsformen der Erfindung kann der Diamant in einer Hochdrucksynthese erzeugt sein, beispielsweise einem HPHT-Verfahren.

Darüber hinaus kann der Diamant Farbzentren enthalten. Die Farbzentren können aus einem Fremdatom auf einem Gitterplatz und einer benachbarten Fehlstelle bestehen. In einigen Ausführungsformen der Erfindung kann das Fremdatom ein Stickstoffatom sein, so dass das Farbzentrum ein NV-Zentrum ist. Das Farbzentrum kann positiv oder negativ geladen oder neutral sein. Zur Bestimmung eines Magnetfelds mit dem vorgeschlagenen Magnetometer kann eine spektroskopische Untersuchung des Farbzentrums vorgenommen werden.

Gemäß einer Ausführungsform kann zumindest der erste Spiegel strukturiert sein, so dass dieser eine Mehrzahl von räumlich separierten optischen Resonatoren definiert. Die Strukturierung kann eindimensional erfolgen, so dass sich der Eindruck eines Wellblechs oder benachbarter konvexer bzw. konkaver Rinnen ergibt. In anderen Ausführungsformen der Erfindung kann die Strukturierung zweidimensional erfolgen, so dass eine Mehrzahl runder oder polygonaler Vertiefungen beziehungsweise Erhebungen im Spiegel vorhanden ist, ähnlich einer Blisterverpackung. Die Strukturierung kann eine Mehrzahl von Kugelkalotten aufweisen. In anderen Ausführungsformen der Erfindung kann die Strukturierung auch Freiformflächen einschließen. Die Strukturierung kann durch Maskieren und nachfolgendes nass- oder trockenchemisches Ätzen erfolgen.

Die Strukturierung kann eine Periode bzw. eine Strukturgröße von etwa 10 µm bis etwa 1 mm oder von etwa 20 µm bis etwa 200 µm oder von etwa 10 µm bis etwa 100 µm aufweisen. Die Strukturen können die Wirkung haben, auftreffendes Licht zu reflektieren und dabei auf einen Punkt- oder Linienfokus zu fokussieren. Hierdurch entstehen zwischen dem ersten Spiegel und dem gegenüberliegenden zweiten Spiegel eine Mehrzahl paralleler Strahlengänge, welche räumlich voneinander getrennt sind. Somit ist eine Spektroskopie der NV-Zentren im Diamanten und das nachfolgende Bestimmen magnetischer Felder für jeden räumlich separierten optischen Resonator getrennt möglich, so dass sich eine räumliche Auflösung des Magnetometers ergibt. Bekannte Magnetometer bestimmen hingegen das Magnetfeld als Mittelwert über das gesamte gepumpte Volumen des mit NV-Zentren versehenen Diamanten.

In einigen Ausführungsformen der Erfindung können die einzelnen optischen Resonatoren der Mehrzahl von räumlich separierten optischen Resonatoren parallel zueinander angeordnet sein. In einigen Ausführungsformen der Erfindung können die einzelnen optischen Resonatoren der Mehrzahl von räumlich separierten optischen Resonatoren in einer Matrix angeordnet sind. Somit ist eine Spektroskopie der NV-Zentren im Diamanten und das nachfolgende Bestimmen magnetischer Felder für jeden räumlich separierten optischen Resonator getrennt möglich, so dass sich eine räumliche Auflösung des Magnetometers ergibt.

In einigen Ausführungsformen der Erfindung kann weiterhin zumindest ein optisch aktives Medium im optischen Resonator angeordnet sein. Das optische Medium kann in einigen Ausführungsformen der Erfindung ein Halbleiterlaser sein. Das aktive Medium kann in einigen Ausführungsformen der Erfindung dazu eingerichtet sein, zusammen mit dem optischen Resonator einen Laser zu bilden, wobei der Diamant einen Absorber für die Laserstrahlung darstellt, dessen Absorptionsverhalten vom herrschenden Magnetfeld abhängig ist. Durch Bestimmen der Laserschwelle oder der Schwächung der Laserstrahlung kann das Magnetfeld mit hoher Genauigkeit bestimmt werden.

In anderen Ausführungsformen der Erfindung kann der Diamant ein weiteres aktives Medium darstellen, welches einen optischen Gewinn erzeugt, welcher die Verluste im Resonator kompensiert. Auch in diesem Fall kann der optische Gewinn vom herrschenden Magnetfeld abhängen, so dass der Laser bzw. einzelne Teilstrahlen in Abhängigkeit des Magnetfelds geschwächt werden oder erlöschen.

In einigen Ausführungsformen der Erfindung kann das aktive Medium einen Halbleiterlaser enthalten oder daraus bestehen. In einer anderen Ausführungsform kann das aktive Medium einen oberflächenemittierenden Halbleiterlaser enthalten oder daraus bestehen. In wiederum einer anderen Ausführungsform kann das aktive Medium einen optisch gepumpten oberflächenemittierenden Halbleiterlaser (MECSEL, VECSEL) enthalten oder daraus bestehen. In wiederum einer anderen Ausführungsform kann das aktive Medium einen elektrisch gepumpten Halbleiterlaser (Laserdiode, VCSEL) enthalten oder daraus bestehen. Ein solches aktives Medium zeichnet sich durch hohe Frequenzstabilität aus.

In einigen Ausführungsformen der Erfindung kann der Diamant eine Hintergrund-Absorption von etwa 0,1 cm⁻¹ oder besser aufweisen. Durch die geringe Absorption elektromagnetischer Strahlung im Diamant kann die Finesse des mit dem Diamant versehenen optischen Resonators erhöht sein.

In einigen Ausführungsformen der Erfindung kann die Absorption elektromagnetischer Strahlung im Diamant im Wellenlängenbereich von etwa 680 nm bis etwa 760 nm kleiner als etwa 0,2 cm⁻¹ oder kleiner als etwa 0,1 cm⁻¹ oder kleiner als etwa 0,05 cm⁻¹ oder kleiner als etwa 0,01 cm⁻¹ sein. Der Absorptionskoeffizient kann durch eine UV-VIS-Spektroskopie gemessen werden. Die Messung kann unter Verwendung einer Ulbricht-Kugel zur Detektion des transmittierten Lichtes durchgeführt werden. Die Reflektion an der Oberfläche des Substrates aufgrund des Unterschiedes der Brechungsindizes wird dabei berücksichtigt.

In einigen Ausführungsformen der Erfindung kann die Absorption elektromagnetischer Strahlung im Diamant im Wellenlängenbereich von etwa 680 nm bis etwa 760 nm größer als etwa 0,001 cm⁻¹ sein.

In einigen Ausführungsformen der Erfindung kann der Diamant eine Konzentration von NV⁻-Zentren von 0,5 ppm oder höher aufweisen. Hierdurch wird das Signal-/Rauschverhältnis der Messung weiter erhöht, woraus eine höhere Genauigkeit und/oder eine höhere Sensitivität bei der Messung von Magnetfeldern erzielt werden kann.

In einigen Ausführungsformen der Erfindung kann der verwendete Diamant NV⁻-Zentren in einer Konzentration von weniger als etwa 10,0 ppm oder von weniger als etwa 3,0 ppm oder von weniger als etwa 2,5 ppm oder von weniger als etwa 2,0 ppm enthalten. Die Konzentration der NV⁻-Zentren kann jedoch größer sein als etwa 1 ppm oder größer als etwa 1,5 ppm.

In einigen Ausführungsformen der Erfindung kann der Diamant ein Volumen von etwa 100 µm x 100 µm x 300 µm oder größer aufweisen. In einigen Ausführungsformen der Erfindung kann der Diamant eine Fläche von mehr als etwa 1 mm in der Länge und/oder in der Breite aufweisen. In anderen Ausführungsformen der Erfindung kann der Diamant eine Fläche von mehr als etwa 3 mm in der Länge und/oder in der Breite aufweisen. Der Diamant kann eine Dicke von mehr als etwa 100 µm oder mehr als etwa 500 µm aufweisen. Hierdurch kann das für die Messung zur Verfügung stehende Volumen vergrößert sein, sodass die Sensitivität erhöht sein kann. In einigen Ausführungsformen der Erfindung kann die Dicke größer sein als die Breite und/oder die Länge. Hierdurch kann die Sensitivität verbessert sein.

In einigen Ausführungsformen der Erfindung kann der Diamant eine erste Seite und eine gegenüberliegende zweite Seite aufweisen, wobei der zweite Spiegel als Beschichtung der ersten Seite des Diamanten ausgeführt ist. Dies erlaubt eine mechanisch robuste, optisch präzise und einfache Ausführung.

In einigen Ausführungsformen der Erfindung kann der Diamant eine erste Seite und eine gegenüberliegende zweite Seite aufweisen, wobei der zweite Spiegel eine erste Seite und eine gegenüberliegende zweite Seite aufweist und die zweite Seite des zweiten Spiegels der ersten Seite des Diamanten zugewandt ist. Der zweite Spiegel kann somit als diskretes, separat zu fertigendes Bauelement bereitgestellt werden. Der zweite Spiegel kann auf der ersten Seite des Diamanten aufliegen oder beabstandet zur ersten Seite des Diamanten angeordnet sein. Der zweite Spiegel kann mit dem Diamanten gefügt werden, beispielsweise durch eine Klebung oder Klemmung. Hierdurch kann der Aufbau und/oder die Wartung des Magnetometers erleichtert sein.

In einigen Ausführungsformen der Erfindung kann der Diamant eine erste Seite und eine gegenüberliegende zweite Seite aufweisen, wobei der zweite Spiegel eine erste Seite und eine gegenüberliegende zweite Seite aufweist, die zweite Seite des zweiten Spiegels mit der ersten Seite des Diamanten in Kontakt steht und die erste Seite des zweiten Spiegels strukturiert ist, so dass diese eine Mehrzahl von räumlich separierten optischen Resonatoren definiert. Die Strukturierung des zweiten Spiegels kann identisch oder ähnlich ausgeführt sein wie die Strukturierung des ersten Spiegels. Hierdurch kann das Übersprechen zwischen benachbarten optischen Resonatoren reduziert sein, so dass die räumliche Auflösung verbessert sein kann. Auch in dieser Ausführungsform kann der zweite Spiegel durch Klemmung oder Klebung oder einem Liquid-Bonding-Verfahren mit dem Diamant verbunden sein.

In einigen Ausführungsformen der Erfindung kann der erste Spiegel und/oder der zweite Spiegel Siliziumcarbid oder Quarz enthalten oder daraus bestehen. Diese Materialien können in einfacher Weise durch nass- oder trockenchemisches Ätzen strukturiert werden.

In einigen Ausführungsformen der Erfindung kann der zweite Spiegel eine Reflektivität von mehr als 99 % in zumindest einem Teilspektrum des Lichtes aufweisen, welches vom optischen aktiven Medium emittiert wird. In einer anderen Ausführungsformen der Erfindung kann der zweite Spiel eine Reflektivität von mehr als 99,9 % zumindest in einem Teilspektrum des Lichtes aufweisen, welches vom optischen aktiven Medium emittiert wird. Dies kann jeweils einen Wellenlängenbereich von etwa 1040 nm bis etwa 1045 nm oder von etwa 750 nm bis etwa 1045 nm einschließen. In einigen Ausführungsformen der Erfindung kann der zweite Spiegel eine Reflektivität von nahezu 100 % aufweisen. Durch die erhöhte Reflektivität des zweiten Spiegels kann die Resonatorgüte ansteigen, so dass der Kontrast des Messsignals erhöht sein kann.

In einigen Ausführungsformen der Erfindung kann der erste Spiegel eine Reflektivität von etwa 95% bis etwa 99% oder von etwa 97% bis etwa 99% oder von etwa 98% bis etwa 99% aufweisen. Dies erlaubt es, einen Teil im Resonator propagierenden Lichtes auszukoppeln, um dieses mittels eines Detektors nachzuweisen und aus diesen Messwerten das Magnetfeld zu bestimmen.

In einigen Ausführungsformen der Erfindung kann der erste Spiegel eine erste Seite und eine gegenüberliegende zweite Seite aufweisen, wobei die zweite Seite des ersten Spiegels strukturiert ist und die erste Seite des ersten Spiegels mit der zweiten Seite des Diamanten in Kontakt steht. In einigen Ausführungsformen der Erfindung können somit beide Spiegel an gegenüberliegenden Seiten des etwa quaderförmigen Diamanten befestigt sein, so dass sich ein kompakter und mechanisch robuster Aufbau ergibt.

In einigen Ausführungsformen der Erfindung kann das optionale aktive Medium eine erste Seite und eine gegenüberliegende zweite Seite aufweisen, wobei die erste Seite des aktiven Mediums mit der zweiten Seite des Diamanten in Kontakt steht und der erste Spiegel eine erste Seite und eine gegenüberliegende zweite Seite aufweist, wobei die zweite Seite des ersten Spiegels strukturiert ist und die erste Seite des ersten Spiegels mit der zweiten Seite des aktiven Mediums in Kontakt steht. Da somit die Spiegel, der Diamant und das aktive Medium miteinander verbunden sind, ergibt sich ein kompakter und mechanisch robuster Aufbau. Das vorgeschlagene Magnetometer lässt sich somit auch dann zuverlässig einsetzen, wenn dieses Vibrationen oder starken Beschleunigungen ausgesetzt ist.

In einigen Ausführungsformen der Erfindung kann der optische Resonator eine Finesse von mehr als 300 aufweisen. In anderen Ausführungsformen der Erfindung kann der optische Resonator eine Finesse von mehr als 500 aufweisen. In wiederum anderen Ausführungsformen der Erfindung kann der optische Resonator eine Finesse von mehr als 1000 aufweisen. Der angegebene Wert der Finesse versteht sich dabei für einen optischen Resonator, in welchem sich während der Messung der Finesse der Diamant befindet. Im Allgemeinen wird die Anwesenheit des Diamant die Eigenschaften des Resonators verschlechtern und die Finesse verringern. Der Einfluss des Diamanten auf die Finesse ist somit in den angegebenen Werten enthalten.

In einigen Ausführungsformen der Erfindung kann der optische Resonator eine Finesse von weniger als 8000 aufweisen. In anderen Ausführungsformen der Erfindung kann der optische Resonator eine Finesse von weniger als 4000 aufweisen. In wiederum anderen Ausführungsformen der Erfindung kann der optische Resonator eine Finesse von weniger als 3000 aufwiesen. Hierdurch kann der optische Resonator Gesamtverluste von etwa 0,02 % bis etwa 3,1 % aufweisen. Ein solcher optischer Resonator kann die Sensitivität der Magnetfeldmessung weiter erhöhen. Auch in diesem Fall bezieht sich der angegebene Wert der Finesse aus einen optischen Resonator, in welchem sich während der Messung der Finesse bzw. der Gesamtverluste der Diamant befindet.

In einigen Ausführungsformen der Erfindung kann das Magnetometer weiterhin zumindest einen Detektor enthalten, welcher der zweiten Seite des ersten Spiegels gegenüberliegt. Der Detektor kann dazu eingerichtet sein, Licht nachzuweisen, welches am zweiten Spiegel nicht reflektiert, sondern transmittiert wird.

In einigen Ausführungsformen der Erfindung kann der Detektor ein Fotodiodenarray oder einen CCD-Sensor oder einen CMOS-Sensor aufweisen. Die Detektoren können eine Mehrzahl nebeneinanderliegender Empfangsbereiche bzw. Pixel aufweisen und auf diese Weise einen Zeilensensor bilden. In anderen Ausführungsformen der Erfindung kann das Fotodiodenarray oder der CCD-Sensor oder der CMOS-Sensor zweidimensional ausgeführt sein, so dass eine Mehrzahl lichtempfindlicher Elemente eine Flächenauflösung ermöglichen. Insbesondere im Zusammenwirken mit einer zweidimensionalen Strukturierung des ersten Spiegels kann somit eine zweidimensionale Magnetfeldmessung erfolgen.

In einigen Ausführungsformen der Erfindung kann der Detektor auf mit dem zweiten Spiegel in Kontakt stehen oder beabstandet der ersten Seite des ersten Spiegels gegenüberliegend angeordnet sein. In anderen Ausführungsformen der Erfindung kann zumindest ein optisches Element zwischen dem ersten Spiegel und der Lichteintrittsfläche des Detektors angeordnet sein. Das optische Element kann zumindest eine Linse oder ein Linsenarray enthalten oder daraus bestehen, so dass das aus der ersten Seite des ersten Spiegels austretende Licht auf die lichtempfindlichen Elemente des Detektors fokussiert wird.

In einigen Ausführungsformen der Erfindung kann das Magnetometer eine erste Pumplichtquelle enthalten. Diese kann dazu eingerichtet und bestimmt sein, die NV-Zentren von einem Grundzustand in einen angeregten Zustand zu pumpen, um die optische Absorption des Diamanten in Abhängigkeit des anliegenden Magnetfelds zu beeinflussen.

In einigen Ausführungsformen der Erfindung kann der Diamant zumindest eine Seitenfläche aufweisen, welche die erste Seite und die gegenüberliegende zweite Seite miteinander verbindet, wobei die erste Pumplichtquelle dazu eingerichtet ist, Pumplicht über die Seitenfläche in den Diamanten einzukoppeln. Hierdurch kann eine kompakte Bauweise ermöglicht werden, so dass der Diamant mit seiner ersten Seite nah an ein Objekt herangeführt werden kann, dessen Magnetfeld bestimmt werden soll.

In einigen Ausführungsformen der Erfindung kann die erste Pumplichtquelle dazu eingerichtet sein, Pumplicht mit einer Leistungsdichte von 40 kW·m⁻² bis 150 kW·m⁻² zu erzeugen. Es wurde erkannt, dass die Schwächung des Messlichtes und damit die Schwächung des Messsignales umso höher ist, je höher die Leistung bzw. die Leistungsdichte der ersten Pumplichtquelle ist. Hierdurch kann das Signal-/Rausch-Verhältnis vergrößert sein, so dass die Erfassung des Magnetfeldes mit größerer Genauigkeit oder geringerem apparativen Aufwand erfolgen kann.

In einigen Ausführungsformen der Erfindung kann die erste Pumplichtquelle dazu eingerichtet sein, Pumplicht mit einer Leistungsdichte von 50 kW·m⁻² bis 130 kW·m⁻² zu emittieren. In wiederum anderen Ausführungsformen der Erfindung kann die erste Pumplichtquelle dazu eingerichtet sein, Pumplicht mit einer Leistungsdichte von 60 kW·m⁻² bis etwa 120 kW·m⁻² zu emittieren. Dies kann in einigen Ausführungsformen durch eine erste Pumplichtquelle erfolgen, welche eine Leistung von etwa 1 W bis etwa 6 W bei einem Strahldurchmesser von etwa 150 µm bis etwa 300 µm aufweist. Hierdurch kann der Kontrast des Messsignals und/oder der mögliche Arbeitsbereich mit hohem Kontrast vergrößert werden.

In einigen Ausführungsformen der Erfindung kann das Magnetometer eine zweite Pumplichtquelle enthalten, welche dazu eingerichtet und bestimmt ist, das aktive Medium optisch zu pumpen. In einigen Ausführungsformen der Erfindung kann das aktive Medium zumindest eine Seitenfläche aufweisen, welche die erste Seite und die gegenüberliegende zweite Seite des aktiven Mediums miteinander verbindet, wobei die zweite Pumplichtquelle dazu eingerichtet ist, Pumplicht über die Seitenfläche in das aktive Medium einzukoppeln. Das Pumplicht wird somit orthogonal zur Empfangsrichtung des Detektors eingekoppelt, so dass ein Übersprechen des Pumplichtes in den Detektor reduziert ist.

In einigen Ausführungsformen der Erfindung kann der Magnetfeldsensor weiterhin zumindest eine HF-Einrichtung aufweisen, mit welcher Mikrowellenstrahlung zumindest am Ort des Diamant erzeugbar ist. In einigen Ausführungsformen der Erfindung kann die Mikrowellenstrahlung eine Frequenz von etwa 2,77 GHz bis etwa 2,97 GHz aufweisen. In anderen Ausführungsformen der Erfindung kann die Mikrowellenstrahlung eine Frequenz von etwa 1,9 GHz bis etwa 3,84 GHz aufweisen. In einigen Ausführungsformen der Erfindung kann die Frequenz der Mikrowellenstrahlung während der Messung verändert werden. Dieses Merkmal bewirkt, dass innerhalb des Grundzustandes ³A Elektronen aus dem Grundzustand mit der Spinquantenzahl 0 in den angeregten Zustand mit der Spinquantenzahl ± 1 angeregt werden. Da die Entartung der Spinzustände +1 und -1 bei Anwesenheit eines Magnetfeldes aufgehoben wird, kann die Höhe eines Magnetfeldes aus der energetischen Aufspaltung der beiden Energieniveaus durch ein resonantes Mikrowellenfeld bestimmt werden.

Bei der Bestimmung eines Magnetfeldes mit dem erfindungsgemäßen Magnetfeldsensor kann die Sensitivität geringer als etwa 100 $pT / \sqrt{Hz}$ sein. In anderen Ausführungsformen der Erfindung kann die Sensitivität geringer als etwa 10 $pT / \sqrt{Hz}$ sein. In wiederum anderen Ausführungsformen der Erfindung kann die Sensitivität geringer als etwa 1 $pT / \sqrt{Hz}$ sein. Somit ist eine genauere Bestimmung des Magnetfeldes bei guter Ortsauflösung möglich.

In einigen Ausführungsformen der Erfindung kann das Verfahren zur Erfassung eines Magnetfeldes bei Raumtempertaur durchgeführt werden. In einigen Ausführungsformen der Erfindung kann das Verfahren zur Erfassung eines Magnetfeldes bei einer Temperatur von mehr als 260 K oder mehr als 280 K durchgeführt werden. Hierdurch wird der mit der Erzeugung kryogener Temperaturen verbundene Aufwand eingespart.

In einigen Ausführungsformen der Erfindung kann das Verfahren Magnetfeldmessung eine Gradiometrie einschließen. Hierdurch können störende Magnetfelder, die nicht von der zu messenden Probe verursacht werden, kompensiert werden. Dies kann in einigen Ausführungsformen der Erfindung dadurch erfolgen, dass die Signale mehrerer räumlich voneinander separierte Strahlengänge bzw. Teilresonatoren jeweils eine Überlagerung der Messgröße und des störenden Magnetfeldes erfassen. Dabei wird ein Magnetfeld, welches räumlich homogen ist und daher auf alle Teilresonatoren gleichzeitig einwirkt, bei der Signalauslese oder -verarbeitung kompensiert, sodass nur noch die Messgröße dargestellt wird.

In einigen Ausführungsformen der Erfindung kann die Signalauslese oder -verarbeitung die Subtraktion eines Offset-Wertes enthalten oder daraus bestehen. In einigen Ausführungsformen der Erfindung kann der Offset-Wert ein Mittelwert aller in den Teilresonatoren erfasster Messwerte sein. In anderen Ausführungsformen der Erfindung kann der Offset-Wert ein Minimalwert aller in den Teilresonatoren erfasster Messwerte sein.

Nachfolgend soll die Erfindung anhand von Figuren ohne Beschränkung des allgemeinen Erfindungsgedankens näher erläutert werden. Dabei zeigt:
Figur 1 ein Magnetometer gemäß einer ersten Ausführungsform.
Figur 2 zeigt ein Magnetometer gemäß einer zweiten Ausführungsform.
Figur 3 zeigt ein Magnetometer gemäß einer dritten Ausführungsform.

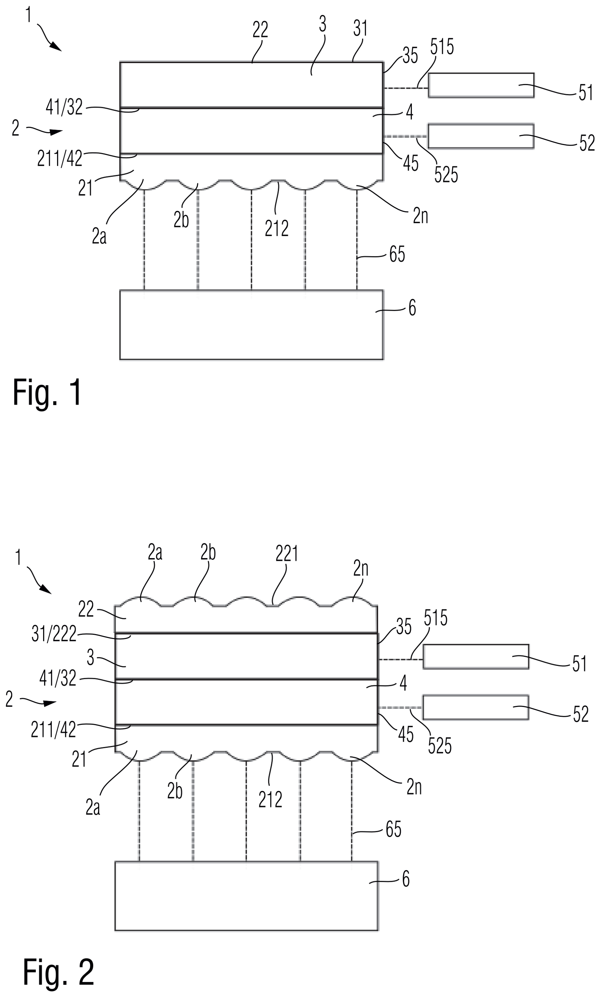

Figur 1 zeigt eine erste Ausführungsform eines Magnetometers im Schnitt. Dargestellt ist ein Diamant 3, welcher eine in etwa quaderförmige oder prismatische oder zylindrische Grundform aufweist. Der Diamant kann eine Grundfläche von etwa 100 µm x 300 µm oder größer aufweisen. Die in Figur 1 dargestellte Dicke kann ebenfalls etwa 100 µm betragen. Der Diamant kann polykristallin oder einkristallin sein. Im Diamant sind Farbzentren angeordnet, insbesondere NV-Zentren, welche aus einem Stickstoffatom auf einem Gitterplatz und einer benachbarten Vakanz bestehen.

Der Diamant 3 weist eine erste Seite 31 und eine gegenüberliegende zweite Seite 32 auf. Die erste und zweite Seite bezeichnet dabei jeweils die größte Seite bzw. die Grundfläche eines quaderförmigen Diamant. Die erste Seite 31 und die gegenüberliegende zweite Seite 32 sind mit zumindest einer Seitenfläche 35 miteinander verbunden. Der Diamant 3 muss nicht zwingend quaderförmig sein. Der Diamant 3 kann auch eine andere polygonale oder runde Grundfläche aufweisen und somit die Grundform eines Zylinders oder eines Prismas aufweisen.

In der in Figur 1 dargestellten Ausführungsform ist die erste Seite 31 mit einem zweiten Spiegel 22 versehen. Der zweite Spiegel 22 ist als Planspiegel ausgeführt. Der zweite Spiegel 22 kann als diskretes Bauelement gefertigt sein und durch Klebung oder Klemmung mit der ersten Seite 31 des Diamant 3 verbunden werden. In anderen Ausführungsformen der Erfindung kann der zweite Spiegel 22 als reflektierende Beschichtung der ersten Seite 31 des Diamanten 3 ausgeführt sein. Die Beschichtung kann eine Mehrzahl von Einzelschichten enthalten, welche einen reflektierenden Interferenzfilter bilden. Die Reflektivität kann im Wellenlängenbereich von etwa 1040 nm bis etwa 1045 nm oder von etwa 700 nm bis etwa 1050 nm größer als 99% oder größer als 99,7% oder größer als 99,9% sein. Dies kann die Wellenlänge oder den Wellenlängenbereich einschließen, in welchem das aktive Medium 4 Licht emittiert.

Weiterhin weist das Magnetometer eine erste Pumplichtquelle 51 auf. Bei Betrieb der Vorrichtung emittiert die erste Pumplichtquelle 51 Pumplicht 515. Dieses kann eine Wellenlänge von etwa 500 nm bis etwa 575 nm aufweisen. Die erste Pumplichtquelle 51 kann beispielsweise ein Diodenlaser oder ein Faserlaser sein. Bei Betrieb des Magnetometers wird das Pumplicht 515 über eine Seitenfläche 35 in den Diamant 3 einkoppelt. Im dargestellten Ausführungsbeispiel wird das Pumplicht 515 entlang des Normalenvektors der Seitenfläche 35 eingekoppelt. In anderen Ausführungsformen kann das Pumplicht 515 mit dem Normalenvektor der Seitenfläche 35 einen Winkel einschließen, welcher von 0° verschieden ist.

Das Pumplicht 515 ist dazu eingerichtet und bestimmt, in an sich bekannter Weise die NV-Zentren des Diamant in einen angeregten Zustand zu pumpen. Hierdurch kann entweder eine Besetzungsinversion erzeugt werden, welche den Diamant zu einem aktiven Lasermedium macht, dessen optischer Gewinn vom anliegenden Magnetfeld abhängig ist. In anderen Ausführungsformen der Erfindung kann der Diamant 3 ein Absorber sein, welcher das vom aktiven Medium ausgehende Licht absorbiert. Auch in diesem Fall ist die Absorption vom einwirkenden Magnetfeld abhängig.

Im dargestellten Ausführungsbeispiel enthält das Magnetometer weiterhin ein optionales aktives Medium 4. Das aktive Medium 4 weist eine erste Seite 41 und eine gegenüberliegende zweite Seite 42 auf. Die erste Seite 41 und die zweite Seite 42 sind wiederum die jeweils größten Flächen bzw. Grundflächen des aktiven Mediums 4. Das aktive Medium 4 kann eine identische Form und Größe aufweisen wie der Diamant 3. Das aktive Medium 4 kann mit seiner ersten Seite 41 auf die zweite Seite 32 des Diamanten 3 aufgebracht sein. Optional kann eine stoffschlüssige Verbindung zwischen dem aktiven Medium 4 und dem Diamanten 3 bestehen, beispielsweise durch Kleben.

Das aktive Medium 4 kann ein Halbleiterlaser sein, welcher optisch gepumpt werden kann. Hierzu steht eine zweite Pumplichtquelle 52 zur Verfügung, welche bei Betrieb des Magnetometers Pumplicht 525 über eine Seitenfläche 45 in das aktive Medium 4 einkoppelt. Im dargestellten Ausführungsbeispiel wird das Pumplicht 525 entlang des Normalenvektors der Seitenfläche 45 eingekoppelt. In anderen Ausführungsformen kann das Pumplicht 525 mit dem Normalenvektor der Seitenfläche 45 einen Winkel einschließen, welcher von 0° verschieden ist.

Weiterhin weist das Magnetometer einen ersten Spiegel 21 auf. Der erste Spiegel 21 weist eine ebene erste Seite 211 auf. Der erste Spiegel 21 kann mit seiner ersten Seite 211 mit der zweiten Seite 42 des optionalen aktiven Mediums 4 oder mit der zweiten Seite 32 des Diamant 3 verbunden sein.

Weiterhin weist der erste Spiegel 21 eine gegenüberliegende zweite Seite 212 auf. Die zweite Seite 212 ist mit einer Strukturierung versehen. Die Strukturierung kann eine Mehrzahl von konvexen Teilflächen aufweisen, welche Licht, welches an deren Innenseite reflektiert wird, fokussieren. Die Strukturierung kann eindimensional sein, so dass sich der optische Eindruck eines Wellbleches ergibt und die Strukturen einen Linienfokus erzeugen. In anderen Ausführungsformen der Erfindung kann die Struktur zweidimensional ausgeführt sein, so dass sich der Eindruck einer Mehrzahl von Kugelkalotten ergibt. Selbstverständlich müssen die Strukturen nicht kugelförmig sein, sondern können auch Freiformflächen enthalten. Hierdurch bilden die Strukturen jeweils einen punktförmigen Fokus. Das so fokussierte Licht wird am gegenüberliegenden ersten Spiegel reflektiert und durchläuft den Resonator 2 mehrfach.

Durch die Strukturierung der zweiten Seite 212 des ersten Spiegels 21 bilden sich im Resonator mehrere, räumlich voneinander separierte Strahlengänge bzw. Teilresonatoren 2a, 2b, ..., 2n, indem das Licht am ersten Spiegel 21 fokussiert und am zweiten Spiegel 22 reflektiert wird. Die Figuren zeigen fünf nebeneinander angeordnete Teilresonatoren 2a, 2b, ..., 2n. Diese Anzahl ist lediglich als beispielhafte Illustration zu sehen. In einigen Ausführungsformen der Erfindung können zwischen etwa 5 und etwa 200 Teilresonatoren 2a, 2b, ..., 2n vorhanden sein. In anderen Ausführungsformen der Erfindung können zwischen etwa 20 und etwa 100 Teilresonatoren 2a, 2b, ..., 2n vorhanden sein. In wiederum anderen Ausführungsformen der Erfindung können zwischen etwa 60 und etwa 120 Teilresonatoren 2a, 2b, ..., 2n vorhanden sein.

Der erste Spiegel 21 weist eine Reflektivität von etwa 95% bis etwa 99% auf. Somit werden zwischen etwa 1% und etwa 5% des auftreffenden Lichtes transmittiert. Das transmittierte Licht 65 erreicht einen Detektor 6. Der Detektor 6 kann als Zeilen- bzw. Liniendetektor eine Mehrzahl beabstandeter lichtempfindlicher Elemente aufweisen. Alternativ kann der Detektor 6 ein Flächendetektor sein, beispielsweise ein zweidimensionales Fotodiodenarray oder ein CCD-Sensor oder ein CMOS-Sensor. Somit kann für jeden Teilresonator 2a, 2b, ..., 2n die Intensität des austretenden Lichtes 65 erfasst werden. Da jeder Teilresonator 2a, 2b, ..., 2n an einem unterschiedlichen Ort lokalisiert ist, kann das einwirkende Magnetfeld ebenfalls ortsabhängig bestimmt werden.

Der Betrieb des vorgestellten Magnetometers erfolgt in an sich bekannter Weise als Laserschwellenmagnetometer , d.h., in Abhängigkeit des anliegenden Magnetfelds kommt es in einzelnen Raumbereichen bzw. Teilresonatoren 2a, 2b, ..., 2n des Resonators 2 zu stimulierter Emission. In anderen Teilbereichen kommt es zu einer magnetfeldabhängigen Absorption des Lichtes, so dass die stimulierte Emission reduziert ist oder erlischt. Durch ortsaufgelöste Erfassung des austretenden Lichtes 65 kann somit das Magnetfeld ortsaufgelöst erfasst werden.

In einigen Ausführungsformen der Erfindung können der erste und zweite Spiegel 21, 22 auch vertauscht werden und/oder der Detektor 6 kann auf der dem Diamant zugewandten Seite des Resonators angeordnet sein.

Anhand der Figur 2 wird eine zweite Ausführungsform der Erfindung näher erläutert. Dabei sind gleiche Bestandteile der Erfindung mit den gleichen Bezugszeichen versehen. Die nachfolgende Beschreibung beschränkt sich auf die wesentlichen Unterschiede zur vorangegangenen Ausführungsform.

Wie Figur 2 zeigt, ist in der zweiten Ausführungsform auch der zweite Spiegel 22 mit einer Strukturierung versehen. Auch der zweite Spiegel 22 weist eine erste Seite 221 und eine gegenüberliegende zweite Seite 222 auf. Die zweite Seite 222 ist eben ausgeführt und auf die erste Seite 31 des Diamant 3 aufgebracht.

Die dem Diamanten abgewandte erste Seite 221 ist mit einer Mehrzahl von konvexen Strukturen versehen. Diese können gleichartig zu den Strukturen des ersten Spiegels 21 ausgebildet und auf diese ausgerichtet sein. Durch die beidseitig fokussierende Wirkung der sich gegenüberstehenden ersten und zweiten Spiegel 21 und 22 kann die räumliche Trennung der optischen Teilresonatoren 2a, 2b, ..., 2n verbessert sein, so dass das Übersprechen zwischen benachbarten Resonatoren reduziert und die räumliche Auflösung der Magnetfeldmessung verbessert ist.

Ausgehend von den beschriebenen Grundformen wird der Fachmann leicht weitere Varianten und Alternativen zur Ausführung der Erfindung auffinden. Beispielsweise kann im Falle eines strukturierten zweiten Spiegels 22 der erste Spiegel 21 auch plan ausgeführt sein. Dies kann durch Beschichtung der zweiten Seite 42 des aktiven Mediums 4 ausgeführt sein. In einigen Ausführungsformen der Erfindung kann das aktive Medium 4 auch entfallen, so dass der erste Spiegel 21 mit der zweiten Seite 32 des Diamanten 3 in Kontakt steht. In einigen Ausführungsformen der Erfindung kann das Pumplicht 515 bzw. 525 auch über die erste Seite 31 bzw. die zweite Seite 42 in den Diamanten bzw. das aktive Medium eingebracht werden. Auch wenn sich die Einkopplung des Pumplichts über die Seitenflächen 35 bzw. 45 als vorteilhaft darstellt, lehrt die Erfindung dies nicht als zwingendes Lösungsprinzip. In einigen Ausführungsformen der Erfindung kann der Detektor 6 auch dem zweiten Spiegel 22 gegenüberliegend angeordnet werden.

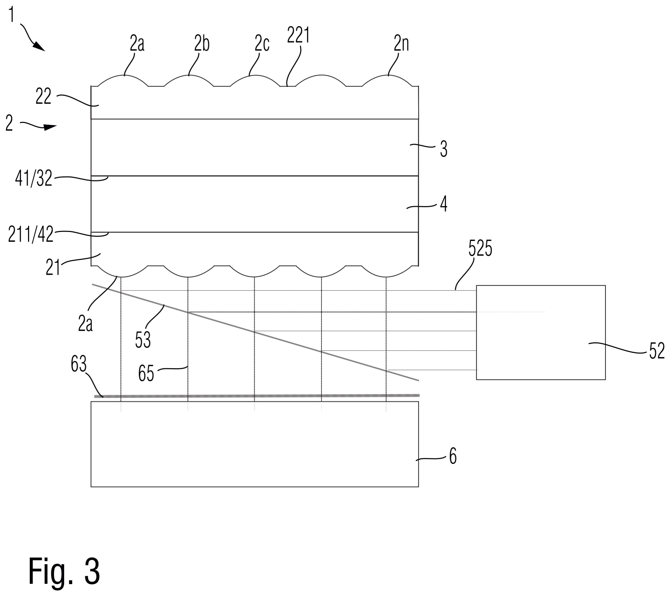

Figur 3 zeigt ein Magnetometer gemäß einer dritten Ausführungsform der Erfindung. Dabei sind gleiche Bestandteile der Erfindung wiederum mit gleichen Bezugszeichen versehen. Die nachfolgende Beschreibung beschränkt sich auf die wesentlichen Unterschiede zu den vorangegangenen Ausführungsformen.

Wie aus Fig. 3 ersichtlich ist, befindet sich zwischen dem ersten Spiegel 21 und dem Detektor 6 ein Einkoppelspiegel 53. Der Einkoppelspiegel 53 kann ein dichroitischer Spiegel sein, welcher Licht einer vorgebbaren Wellenlänge oder eines Wellenlängenbereiches reflektiert und Licht einer anderen Wellenlänge oder eines Wellenlängenbereiches transmittiert. Wie aus Fig. 3 ersichtlich ist, ist der Einkoppelspiegel 53 gegenüber dem Normalenvektor des ersten Spiegels 21 und des Detektors 6 geneigt, so dass dieser dazu eingerichtet ist, Pumplicht 525 aus der seitlich angeordneten Pumplichtquelle 52 zu reflektieren und in das aktive Medium 4 einzukoppeln.

Das vom ersten Spiegel 21 transmittierte Licht 65 wird vom Einkoppelspiegel 53 transmittiert und erreicht den Detektor 6. Vor dem Detektor 6 kann ein optionaler Filter 63 angeordnet sein, welcher das vom ersten Spiegel 21 transmittierte Licht 65 passieren lässt und das Pumplicht 525 absorbiert, so dass dieses nicht in den Detektor 6 gelangt.

Selbstverständlich ist die Erfindung nicht auf die dargestellten Ausführungsformen beschränkt. Die vorstehende Beschreibung ist daher nicht als beschränkend, sondern als erläuternd anzusehen. Die nachfolgenden Ansprüche sind so zu verstehen, dass ein genanntes Merkmal in zumindest einer Ausführungsform der Erfindung vorhanden ist. Dies schließt die Anwesenheit weiterer Merkmale nicht aus. Die nachfolgenden Ansprüche sind nicht so zu verstehen, dass ein genanntes Merkmal in jeder Ausführungsform der Erfindung vorhanden ist. Sofern die Ansprüche und die vorstehende Beschreibung "erste" und "zweite" Ausführungsformen definieren, so dient diese Bezeichnung der Unterscheidung zweier gleichartiger Ausführungsformen, ohne eine Rangfolge festzulegen.

## Patentansprüche

1. Magnetometer (1) mit zumindest einem optischen Resonator (2), welcher einen ersten Spiegel (21) und zumindest einen zweiten Spiegel (22) enthält, wobei im optischen Resonator zumindest ein Diamant (3) angeordnet ist, welcher zumindest ein NV-Zentrum enthält, **dadurch gekennzeichnet, dass**
zumindest der erste Spiegel (21) strukturiert ist, so dass dieser eine Mehrzahl von räumlich separierten optischen Resonatoren (2a, 2b, ..., 2n) definiert.

2. Magnetometer nach Anspruch 1, **dadurch gekennzeichnet, dass** weiterhin zumindest ein aktives Medium (4) im optischen Resonator angeordnet ist oder
dass weiterhin zumindest ein aktives Medium (4) im optischen Resonator (2) angeordnet ist, welches einen Halbleiterlaser enthält oder daraus besteht.

3. Magnetometer nach Anspruch 1 oder 2, **dadurch gekennzeichnet, dass** die einzelnen optischen Resonatoren (2a, 2b, ..., 2n) der Mehrzahl von räumlich separierten optischen Resonatoren (2a, 2b, ..., 2n) parallel zueinander angeordnet sind und/oder
dass die einzelnen optischen Resonatoren (2a, 2b, ..., 2n) der Mehrzahl von räumlich separierten optischen Resonatoren (2a, 2b, ..., 2n) in einer Matrix angeordnet sind.

4. Magnetometer nach einem der Ansprüche 1 bis 3, **dadurch gekennzeichnet, dass** der zweite Spiegel (22) eine Reflektivität von mehr als etwa 99% bis etwa 99,9% in zumindest einem Teilspektrum des Lichtes aufweist, welches vom optischen aktiven Medium emittiert wird oder dass der Diamant (3) eine erste Seite (31) und eine gegenüberliegende zweite Seite (32) aufweist, wobei der zweite Spiegel (22) als Beschichtung der ersten Seite (31) des Diamant (3) ausgeführt ist oder
dass der Diamant (3) eine erste Seite (31) und eine gegenüberliegende zweite Seite (32) aufweist, wobei der zweite Spiegel (22) eine erste Seite (221) und eine gegenüberliegende zweite Seite (222) aufweist und die zweite Seite (222) des zweiten Spiegels (22) der ersten Seite (31) des Diamant (3) zugewandt ist oder
dass der Diamant (3) eine erste Seite (31) und eine gegenüberliegende zweite Seite (32) aufweist, wobei der zweite Spiegel (22) eine erste Seite (221) und eine gegenüberliegende zweite Seite (222) aufweist, die zweite Seite (222) des zweiten Spiegels (22) mit der ersten Seite (31) des Diamant (3) in Kontakt steht und die erste Seite (221) des zweiten Spiegels (22) strukturiert ist, so dass dieser eine Mehrzahl von räumlich separierten optischen Resonatoren (2a, 2b, ..., 2n) definiert.

5. Magnetometer nach einem der Ansprüche 1 bis 4, **dadurch gekennzeichnet, dass** der erste Spiegel (21) SiC oder Quarz enthält oder daraus besteht und/oder dass der erste Spiegel (21) eine Reflektivität von etwa 95% bis etwa 99% in zumindest einem Teilspektrum des Lichtes aufweist, welches vom optischen aktiven Medium emittiert wird und/oder
dass der erste Spiegel (21) eine erste Seite (211) und eine gegenüberliegende zweite Seite (212) aufweist und die zweite Seite (212) des ersten Spiegels (21) strukturiert ist und die erste Seite (211) des ersten Spiegels (21) mit der zweiten Seite (32) des Diamant (3) in Kontakt steht oder
dass das aktive Medium (4) eine erste Seite (41) und eine gegenüberliegende zweite Seite (42)aufweist, wobei die erste Seite (41) des aktiven Mediums (4) mit der zweiten Seite (32) des Diamant (3) in Kontakt steht und der erste Spiegel (21) eine erste Seite (211) und eine gegenüberliegende zweite Seite (212) aufweist und die zweite Seite (212) des ersten Spiegels (21) strukturiert ist und die erste Seite (211) des ersten Spiegels (21) mit der zweiten Seite (42) des aktiven Mediums (4) in Kontakt steht.

6. Magnetometer nach einem der Ansprüche 1 bis 5, **dadurch gekennzeichnet, dass** dieses weiterhin einen Detektor (6) aufweist, welcher der zweiten Seite (212) des ersten Spiegels (21) gegenüberliegt und/oder
dass dieses weiterhin einen Detektor (6) aufweist, welcher ein Photodiodenarray oder einen CCD-Sensor oder einen CMOS-Sensor aufweist und/oder
dass dieses weiterhin einen Detektor (6) aufweist, welcher dazu eingerichtet ist, ein zweidimensionales Bild des ersten Spiegels zu erfassen.

7. Magnetometer nach Anspruch 6, weiterhin enthaltend zumindest ein optisches Element, welches zwischen der zweiten Seite (212) des ersten Spiegels (21) und dem Detektor (6) angeordnet ist.

8. Magnetometer nach einem der Ansprüche 1 bis 7, **dadurch gekennzeichnet, dass** dieses weiterhin eine erste Pumplichtquelle (51) enthält und
dass der Diamant (3) zumindest eine Seitenfläche (35) enthält, welche die erste Seite (31) und die gegenüberliegende zweite Seite (32) miteinander verbindet, wobei die erste Pumplichtquelle (51) dazu eingerichtet ist, Pumplicht (515) über die Seitenfläche (35) in den Diamant (3) einzukoppeln.

9. Magnetometer nach einem der Ansprüche 2 bis 8, **dadurch gekennzeichnet, dass** dieses weiterhin eine zweite Pumplichtquelle (52) enthält und
dass das aktive Medium (4) zumindest eine Seitenfläche (45) enthält, welche die erste Seite (41) und die gegenüberliegende zweite Seite (42) miteinander verbindet, wobei
die zweite Pumplichtquelle (52) dazu eingerichtet ist, Pumplicht (525) über die Seitenfläche (45) in das aktive Medium (4) einzukoppeln.

10. Verfahren zur Erfassung eines Magnetfeldes mit folgenden Schritten:
Bereitstellen eines Magnetometers (1) mit zumindest einem optischen Resonator (2), welcher einen ersten Spiegel (21) und einen gegenüberliegenden zweiten Spiegel (22) enthält, wobei im optischen Resonator und zumindest ein Diamant (3) angeordnet ist, welcher zumindest ein NV-Zentrum enthält, und zumindest der erste Spiegel (21) strukturiert ist, so dass dieser eine Mehrzahl von räumlich separierten optischen Resonatoren (2a, 2b, ..., 2n) definiert;
Einkoppeln von erstem Pumplicht (515) in den Diamant (3);
Einwirken eines Magnetfeldes auf zumindest ein Teilvolumen des Magnetometers (1);
Räumlich aufgelöstes Erfassen von Licht, welches aus den optischen Resonatoren (2a, 2b, ..., 2n) austritt, um aus dessen Intensität das Magnetfeld innerhalb von zumindest einem optischen Resonator (2a, 2b, ..., 2n) zu bestimmen.

11. Verfahren nach Anspruch 10, **dadurch gekennzeichnet, dass** im optischen Resonator (2) weiterhin zumindest ein aktives Medium (4) angeordnet ist, in welches zweites Pumplicht (525) eingekoppelt wird.

12. Verfahren nach einem der Ansprüche 10 oder 11, **dadurch gekennzeichnet, dass** das erste Pumplicht (515) eine Wellenlänge von etwa 500 nm bis etwa 575 nm aufweist.

13. Verfahren nach einem der Ansprüche 10 bis 12, **dadurch gekennzeichnet, dass** am Ort des Diamant Mikrowellenstrahlung erzeugt wird.

14. Verfahren nach einem der Ansprüche 10 bis 13, **dadurch gekennzeichnet, dass** dieses eine Gradiometrie einschließt.

15. Verfahren nach einem der Ansprüche 13 oder 14, **dadurch gekennzeichnet, dass** die Mikrowellenstrahlung eine Frequenz von etwa 2,77 GHz bis etwa 2,97 GHz aufweist oder
dass die Mikrowellenstrahlung eine Frequenz von etwa 1,9 GHz bis etwa 3,84 GHz aufweist.
